# EUROPÄISCHE PATENTANMELDUNG

(11) **EP 1 178 606 A2**
(43) Veröffentlichungstag der Anmeldung: **06.02.2002**
(21) Anmeldenummer: 01118563.4
(22) Anmeldetag: 01.08.2001
(51) Int. Cl.: H03K 17/082

(54) **Überstromgeschützter Halbleiterleistungsschalter, insbesondere zum Schalten niederohmiger Lasten**

(30) Priorität: 04.08.2000 DE 10038221
(71) Anmelder: Infineon Technologies AG, 81669 München (DE)
(72) Erfinder: Oyrer, Robert, 9500 Villach (AT)
(74) Vertreter: Müller . Hoffmann & Partner Patentanwälte

(57) **Zusammenfassung**

Die Erfindung betrifft einen Leistungshalbleiterschalter mit einer zwischen dem Gateanschluss (G) eines Feldeffektleistungstransistors (1) und dessen an der Last (L) liegendem Ausgangsanschluss (4) eingeschalteten Strombegrenzungsschaltung (10) und einer mit diesem Gateanschluss (G) verbundenen Ladungspumpe (5, 6, 7), mit der dem Gate (G) des Leistungstransistors (1) ein Ladestrom injiziert wird. Die Strombegrenzungsschaltung (10) hat einen ersten Zweig (12) für die Begrenzung des durch die Last (L) und den Leistungstransistor (1) fließenden Stroms (Iₒᵤₜ) wenn die Drain-Source-Spannung des Leistungstransistors (1) einen bestimmten Spannungswert (V_{S}) überschreitet, und einen zweiten zum ersten Zweig (12) parallelen Zweig (11) für die Begrenzung des durch die Last (L) und den Leistungstransistor (1) fließenden Stroms (Iₒᵤₜ), wenn die Drain-Source-Spannung des Leistungstransistors (1) den bestimmten Wert (V_{S}) unterschreitet.

## Beschreibung

Die Erfindung betrifft einen Leistungshalbleiterschalter, insbesondere zum Schalten einer niederohmigen Last gemäß dem Oberbegriff des Patentanspruchs 1. Ein derartiger Leistungshalbleiterschalter ist aus DE 196 35 332 A1 (SIEMENS AG) bekannt.

Dem Schalten von möglichst niederohmigen Lasten steht bei dem mit einer Strombegrenzung und einer Ladungspumpe ausgestatteten bekannten Leistungshalbleiterschalter derzeit der ladungspumpenbedingte Einbruch der Strombegrenzung bei Spannungen kleiner als 6 V am Leistungstransistor entgegen.

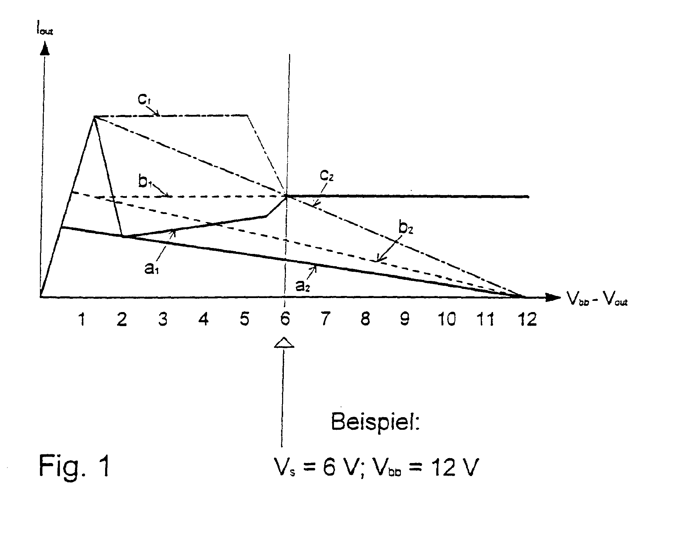

In der beiliegenden Figur 1 sind Ausgangskennlinien dargestellt, die verschiedene Verläufe des Ausgangsstroms Iₒᵤₜ durch eine niederohmige Last in Abhängigkeit von der Source-Drain-Spannung, d. h. der Differenz V_{bb} - Vₒᵤₜ zwischen der Betriebsspannung V_{bb} des Leistungstransistors und der am Ausgangsanschluss liegenden, d. h. an einer Last abfallenden Ausgangsspannung Vₒᵤₜ bei unterschiedlich wirkenden Strombegrenzungen zeigen. In Fig. 1 ist beispielhaft angenommen, dass ein derartiger überstromgeschützter Leistungshalbleiterschalter mit der Betriebsspannung V_{bb} = 12 V betrieben wird. Die ausgezogene Kennlinie a₁ zeigt den durch die bekannte Strombegrenzung erreichten Verlauf des Ausgangsstroms Iₒᵤₜ; die ebenfalls ausgezogen gezeichnete Kennlinie a₂ stellt den derzeitigen Verlauf dar, wenn ein Lastwiderstand in den vom Ausgangsanschluss des Leistungshalbleiterschalters zur Last führenden Stromkreis eingeschaltet ist; der punktiert gezeichnete Stromverlauf b₁ stellt einen angestrebten geraden Verlauf der Strombegrenzung dar, und der ebenfalls punktiert eingezeichnete Stromverlauf b₂ zeigt einen Stromverlauf gemäß b₁ bei eingeschaltetem Lastwiderstand. Die strichpunktiert gezeigte Kennlinie c₁ stellt einen Stromverlauf bei Überhöhung der Strombegrenzung und die Kennlinie c₂ einen Stromverlauf mit eingeschaltetem Lastwiderstand bei einer Überhöhung der Strombegrenzung gemäß der Kennlinie c₁ dar.

Es ist somit wünschenswert, dass der Stromverlauf Iₒᵤₜ entweder - wie die Kennlinie b₁ darstellt - einen geraden Verlauf nimmt, bei dem Iₒᵤₜ im Wesentlichen konstant ist oder sogar eine Überhöhung gemäß der Kennlinie c₁. Die bekannte Strombegrenzungsschaltung enthält einen Strombegrenzungszweig für den Spannungsbereich über der Schwelle Vₛ (6 V) der am Leistungshalbleiter anliegenden Differenzspannung V_{bb} - Vₒᵤₜ, und man nahm den durch den Stromverlauf a₁ in Fig. 1 dargestellten Einbruch und die damit verbundene Einschränkung des Einsatzbereichs unterhalb der Schwelle Vₛ in Kauf. Abhilfe konnte bislang nur durch eine Erhöhung der Kapazität der Ladungspumpe erreicht werden. Dies lässt sich jedoch nur durch die Vergrößerung der von der Ladungspumpe belegten Schaltungsfläche und der Treiber erreichen, wobei der erhöhte Platzbedarf in jedem Fall nachteilig ist.

Bei dem oben erwähnten, aus der DE 196 35 332 A1 bekannten Leistungshalbleiterschalter bewirkt ein Strombegrenzungszweig die Begrenzung des durch die Last und den Leistungshalbleiter FET 1 fließenden Stroms, wenn die Drain-Source-Spannung des FET 1 einen bestimmten Wert überschreitet. Die Strombegrenzung wird dort implizit dadurch erreicht, dass die Drain-Source-Spannung auf einen festen Wert geregelt wird.

Es ist Aufgabe der Erfindung, die oben aufgeführten Nachteile der Strombegrenzung des bekannten Leistungshalbleiterschalters zu vermeiden und einen gattungsgemäßen Leistungshalbleiterschalter zu ermöglichen, der möglichst niederohmige Lasten mit einer Strombegrenzung schalten kann, wie sie z. B. durch die geraden Kennlinien b₁ oder b₂ in Fig. 1 spezifiziert sind.

Durch die erfindungsgemäße Aufteilung der Strombegrenzung in einen zweiten Zweig für den Bereich der Drain-Source-Spannung (V_{bb} - Vₒᵤₜ) kleiner als die Schwellenspannung Vₛ (z. B. 6 V) und einen parallel zum zweiten Zweig liegenden ersten Zweig für Drain-Source-Spannungen V_{bb} - Vₒᵤₜ am Leistungstransistor größer als die Spannungschwelle Vs (6 V), kann der durch die Kennlinie a₁ in Fig. 1 veranschaulichte Einbruch bei unveränderter Ladungspumpe vermieden werden. Der erste Zweig ist dem zweiten Zweig beim Überschreiten der Spannungsschwelle Vₛ zuschaltbar.

Die Zu- bzw. Wegschaltung des ersten Zweiges erfolgt mittels eines abschnürbaren N-Kanal-Feldeffekttransistors vom Verarmungstyp. Dessen Gateanschluss liegt an einem in der übrigen Schaltung bereits vorhandenen Potenzial von V_{bb} - Vs und sein Sourceanschluss am Ausgangsanschluss des Leistungstransistors. Ist nun die Spannung Vₒᵤₜ am Ausgangsanschluss höher als das Gatepotenzial V_{bb} - Vs des N-Kanal-Feldeffekttransistors vom Verarmungstyp, liegt an diesem Transistor eine Gate-Source-Spannung U_{gs} kleiner 0 an, der Transistor schnürt ab, und der erste Zweig der Strombegrenzungsschaltung ist weggeschaltet. Dadurch lässt sich eine an den Stromverlauf b₁ in Fig. 1 angenäherte Ausgangskennlinie erreichen.

Durch die konstruktionsbedingte Abhängigkeit des Innenwiderstands der Ladungspumpe von der Ausgangsspannung ergibt sich dennoch kein absolut gerader Verlauf der Strombegrenzung (wie b₁ in Fig. 1 darstellt). Dazu muss zusätzlich ein weiterer, in seiner Stärke von der Ausgangsspannung Vₒᵤₜ abhängiger Zweig der Strombegrenzungsschaltung eingesetzt werden. Die Steuerung dieses dritten Zweiges erfolgt über einen N-Kanal-Feldeffekttransistor vom Anreicherungstyp, dessen Sourceanschluss mit dem Ausgangsanschluss verbunden ist und dessen Gate mit der Betriebsspannung beaufschlagt ist. Bei sich erniedrigender Source-Drain-Spannung V_{bb} - Vₒᵤₜ am Leistungstransistor sinkt nun die Stromleitfähigkeit des genannten N-Kanal-Feldeffekttransistors vom Anreicherungstyp und damit des genannten dritten Zweiges der Strombegrenzungsschaltung, wodurch eine Kompensation des Verhaltens der Ladungspumpe erreicht ist. Allerdings darf zum Schutz des genannten N-Kanal-Feldeffekttransistors vom Anreicherungstyp dessen Gateanschluss nicht direkt mit der Betriebsspannung V_{bb}, sondern mit einem (bereits vorhandenen) mit maximal der Schwellenspannung Vs (6 V) gegen die Ausgangsspannung Vₒᵤₜ geklemmtes Signal beaufschlagt werden.

Durch die Kombination der drei Zweige der Strombegrenzungsschaltung ist es nun möglich, sowohl einen geraden Verlauf der Strombegrenzung (Kennlinien b₁ oder b₂ in Fig. 1) oder auch eine Überhöhung der Strombegrenzung (Verlauf c₁ oder c₂ in Fig. 1) mit einfachen Mitteln praktisch zu realisieren.

Die nachstehende Beschreibung beschreibt ein Ausführungsbeispiel des erfindungsgemäßen Leistungshalbleiterschalters, bezogen auf die Zeichnung. Die Zeichnungsfiguren zeigen im Einzelnen:
- Fig. 1: verschiedene, vorangehend bereits beschriebene Ausgangskennlinien, d. h. Stromverläufe von überstrombegrenzten Leistungshalbleiterschaltern mit Ladungspumpe beim Schalten niederohmiger Lasten;
- Fig. 2: ein schematisches Schaltbild eines Ausführungsbeispiels eines erfindungsgemäßen Leistungshalbleiterschalters; und
- Fig. 3: Ausgangskennlinien, die mit der Strombegrenzung des in Fig. 2 dargestellten Ausführungsbeispiels des erfindungsgemäßen Leistungshalbleiterschalters erreichbar sind.

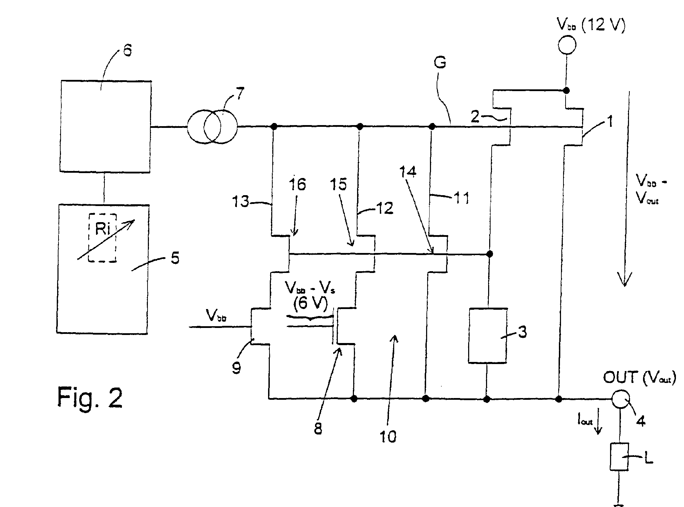

Das in dem Schaltschema der Fig. 2 dargestellte Ausführungsbeispiel eines erfindungsgemäßen Leistungshalbleiterschalters weist in Reihe zu einer Last L die an einem Ausgangsanschluss (OUT) 4 liegt, die Drain-Source-Strecke eines N-Kanal-Leistungsfeldeffekttransistors 1 auf, dem ein Sensezweig, bestehend aus einem FET 2 und einem Shuntwiderstand 3 parallel geschaltet ist. Der Drainanschluss des FETs 1 liegt an Betriebsspannung V_{bb}, die z. B. 12 V beträgt. Der Gateanschluss G des Leistungs-FETs 1 und der Gateanschluss des Sense-FETs 2 sind mit einer Ladungspumpe 5 über einen Gleichrichter 6 und einem als Konstantstromquelle fungierenden Gate-Lade-FET 7 verbunden. Die Ladungspumpe 5 liefert über den Gleichrichter 6 und die Konstantstromquelle 7 einen Gleichstrom, dessen Stärke von der Kapazität, d. h. der Stärke der Ladungspumpe 5 und deren mit der Ausgangsspannung Vₒᵤₜ veränderlichem Innenwiderstand Rᵢ abhängt.

Die Bezugszahl 10 bezeichnet eine Strombegrenzungsschaltung, die drei parallele Zweige 11, 12 und 13 hat. Der Zweig 11 (zweiter Zweig) mit einem Feldeffekttransistor 14 hat die Funktion, den durch die Last L und den FET 1 fließenden Strom zu begrenzen, wenn die Drain-Source-Spannung V_{bb} - Vₒᵤₜ des FETs 1 einen Schwellenwert Vs (6 V) unterschreitet.

Die Aufgabe des parallelen Zweiges 12 (erster Zweig) ist nun, den ladungspumpenbedingten Einbruch der Strombegrenzung bei Drain-Source-Spannungen am Leistungstransistor 1, die größer sind als eine bestimmte Drain-Source-Spannung Vs (im Beispiel 6 V), zu kompensieren. Dazu weist dieser erste Zweig 12 außer einem Feldeffekttransistor 15 einen abschnürbaren N-Kanal-Feldeffekttransistor 8 vom Verarmungstyp auf. Dessen Gateanschluss liegt an einem Potenzial V_{bb} - Vₛ, wobei Vₛ im Beispiel der Figur 2 gleich 6 V ist. Der Sourceanschluss des N-Kanal-Feldeffekttranistors 8 liegt an dem Ausgangsanschluss OUT 4, d. h. an der Ausgangsspannung Vₒᵤₜ an. Ist nun Vₒᵤₜ höher als die Spannungsdifferenz V_{bb} - Vₛ, so liegt am Feldeffekttransistor 8 eine Gate-Source-Spannung U_{gs} kleiner 0 an, der Transistor 8 schnürt ab und der erste Zweig 12 ist weggeschaltet.

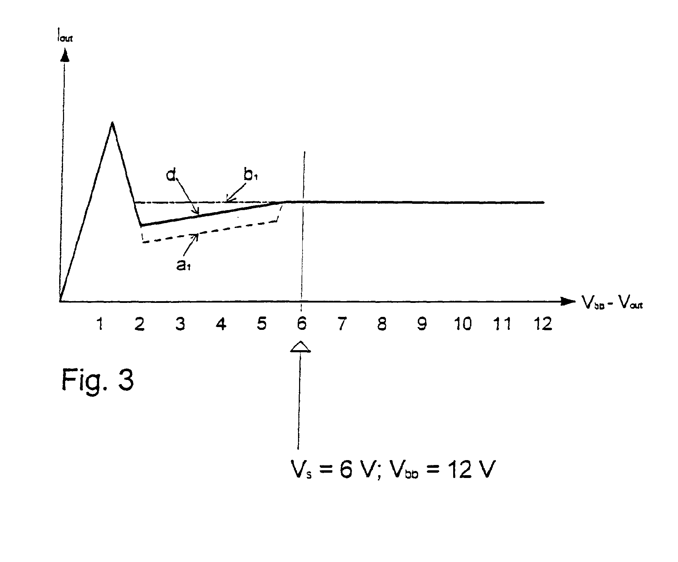

Fig. 3 zeigt die durch den Zweig 12 erreichte verbesserte Ausgangsstromkennlinie d.

Wünschenswert ist jedoch, wie oben erwähnt, ein Verlauf der Ausgangskennlinie gemäß b₁.

Durch die konstruktionsbedingte Abhängigkeit des Innenwiderstandes Rᵢ der Ladungspumpe 5 von der Ausgangsspannung Vₒᵤₜ ergibt sich auch mit der Hinzunahme des ersten Zweigs 12 der Strombegrenzungsschaltung 10 zum zweiten Zweig 11 kein absolut gerader Verlauf der Strombegrenzung gemäß dem Verlauf b1.

Dazu ist im Ausführungsbeispiel vorgesehen, einen dritten parallelen Zweig 13 der Strombegrenzungsschaltung 10 hinzuzufügen, dessen Stärke von der Ausgangsspannung Vₒᵤₜ abhängt. Ein N-Kanal-Feldeffekttransistor 9 vom Anreicherungstyp liegt im dritten Zweig 13, dessen Sourceanschluss am Ausgangsanschluss 4 liegt und dessen Gateanschluss mit V_{bb} beaufschlagt ist.
Die Gateanschlüsse der Feldeffekttransistoren 14, 15 und 16 in den Zweigen 11, 12 und 13 der Strombegrenzungsschaltung 10 sind gemeinsam mit dem am Shuntwiderstand 3 abfallenden Potenzial beaufschlagt.

Bei sich erniedrigender Spannungsdifferenz V_{bb} - Vₒᵤₜ am Leistungsfeldeffekttransistor 1 sinkt die Stromleitfähigkeit des Feldeffekttransistors 9 und damit des gesamten dritten Zweigs 13 der Strombegrenzung 10. Dadurch ist eine Kompensation der Abhängigkeit des Innenwiderstands Rᵢ der Ladungspumpe 5 von der Ausgangsspannung Vₒᵤₜ erreicht. Zum Schutz des N-Kanal-Feldeffekttransistors 9 darf sein Gateanschluss aber nicht direkt an die Bestriebsspannung V_{bb} gekoppelt werden, sondern wird mit einem mit maximal Vₛ (6 V) gegen OUT geklemmten Signal beaufschlagt. Mit dieser Maßnahme lässt sich nun ein absolut gerader Verlauf der Ausgangskennlinie gemäß dem in Fig. 1 und Fig. 3 dargestellten Verlauf b₁ (b₂) der Strombegrenzung wie auch eine Überhöhung (c₁, c₂) mit einfachen Mitteln erreichen.

Selbstverständlich kann in den vom Ausgangsanschluss OUT 4 zur Last L führenden Stromkreis ein (nicht gezeigter) Strombegrenzungswiderstand eingeschaltet werden, um den durch die Linie b2 in Fig. 1 veranschaulichten Verlauf der Ausgangskennlinie zu erreichen.

## Patentansprüche

1. Leistungshalbleiterschalter, insbesondere zum Schalten einer niederohmigen Last (L), mit
- einer zwischen dem Gateanschluss (G) eines Feldeffektleistungstransistors (1) und dessen an der Last (L) liegendem Ausgangsanschluss (4) eingeschalteten Strombegrenzungsschaltung (10) und
- einer mit diesem Gateanschluss (G) verbundenen Ladungspumpe (5, 6, 7), mit der dem Gate (G) des Leistungstransistors (1) ein Ladestrom injiziert wird, wobei
die Strombegrenzungsschaltung (10) einen ersten Zweig (12) aufweist für die Begrenzung des durch die Last (L) und den Leistungstransistor (1) fließenden Stroms (Iₒᵤₜ), wenn die Drain-Source-Spannung des Leistungstransistors (1) einen bestimmten Spannungswert (Vₛ) überschreitet,
**dadurch gekennzeichnet, dass**
die Strombegrenzungsschaltung (10) einen zweiten zum ersten Zweig (12) parallelen Zweig (11) für die Begrenzung des durch die Last (L) und den Leistungstransistor (1) fließenden Stroms (Iₒᵤₜ) aufweist, wenn die Drain-Source-Spannung des Leistungstransistors (1) den bestimmten Wert (Vₛ) unterschreitet.

2. Leistungshalbleiterschalter nach Anspruch 1,
**dadurch gekennzeichnet, dass**
der erste Zweig (12) der Strombegrenzungsschaltung (10) einen abschnürbaren N-Kanal-Feldeffekttransistor (8) vom Verarmungstyp aufweist, durch den der erste Zweig (12) der Strombegrenzungsschaltung (10) dem zweiten Zweig (11) zuschaltbar ist, wenn die an der Last (L) abfallende bzw. am Ausgangsanschluss (4) liegende Ausgangsspannung (Vₒᵤₜ) den bestimmten Spannungswert (Vs) unterschreitet und vom zweiten Zweig (11) der Strombegrenzungsschaltung (10) wegschaltbar ist, wenn die an der Last (L) abfallende bzw. am Ausgangsanschluss (4) liegende Spannung den bestimmten Spannungswert (Vs) überschreitet.

3. Leistungshalbleiterschalter nach Anspruch 2,
**dadurch gekennzeichnet, dass**
der Gateanschluss des N-Kanal-Feldeffekttransistors (8) mit einer Gatespannung beaufschlagt ist, die gleich der um den bestimmten Spannungswert (Vs) verminderten Betriebsspannung (V_{bb}) ist, und dass der Sourceanschluss des N-Kanal-Feldeffekttransistors (8) mit dem Sourceanschluss bzw. mit dem Ausgangsanschluss (4) des Leistungstransistors (1) verbunden ist.

4. Leistungshalbleiterschalter nach einem der Ansprüche 1 bis 3,
**dadurch gekennzeichnet, dass**
die Strombegrenzungsschaltung (10) außerdem einen dritten zum ersten und zweiten Zweig (12, 11) parallelen Zweig (13) aufweist, dessen Stärke von der an der Last (L) abfallenden bzw. am Ausgangsanschluss (4) anliegenden Spannung (Vₒᵤₜ) abhängt.

5. Leistungshalbleiterschalter nach Anspruch 4,
**dadurch gekennzeichnet, dass**
der dritte Zweig (13) einen N-Kanal-Feldeffekttransistor (9) vom Anreicherungstyp aufweist, dessen Sourceanschluss mit dem Sourceanschluss des Leistungstransistors (1) verbunden und dessen Gateanschluss mit einem Teil der Betriebsspannung (V_{bb}) beaufschlagt ist.

6. Leistungshalbleiterschalter nach Anspruch 5,
**dadurch gekennzeichnet, dass**
der Gateanschluss des N-Kanal-Feldeffektransistors (9) mit einem mit höchstens dem bestimmten Spannungswert (Vs) gegen die an der Last (L) abfallende bzw. am Ausgangsanschluss (4) anliegende Ausgangsspannung (Vₒᵤₜ) geklemmten Potenzial beaufschlagt ist.

7. Leistungshalbleiterschalter nach einem der vorangehenden Ansprüche,
**dadurch gekennzeichnet, dass**
er für eine Betriebsspannung V_{bb} = 12 V ausgelegt ist, und dass der bestimmte Spannungswert (Vs) 6 V beträgt.

8. Leistungshalbleiterschalter nach einem der vorangehenden Ansprüche,
**dadurch gekennzeichnet, dass**
außerdem in dem vom Sourcesanschluss des Leistungshalbleiters (1) zur Last (L) führenden Stromkreis ein zuschaltbarer Lastwiderstand vorgesehen ist.
